# EUROPEAN PATENT APPLICATION

(11) **EP 4 521 195 A1**
(43) Date of publication of application: **12.03.2025**
(21) Application number: 24752336.8
(22) Date of filing: 18.07.2024
(51) Int. Cl.: G06F 1/16, C09J 7/00

(54) **ELECTRONIC DEVICE INCLUDING FLEXIBLE DISPLAY AND STRUCTURE THEREOF**

(30) Priority: 20.07.2023 KR 20230094643; 26.09.2023 KR 20230129311
(71) Applicant: Samsung Electronics Co., Ltd, Suwon-si, Gyeonggi-do 16677 (KR)
(72) Inventor: JUNG, Kiyoung, Suwon-si, Gyeonggi-do 16677 (KR); KIM, Hyeonhak, Suwon-si, Gyeonggi-do 16677 (KR); CHUN, Woosung, Suwon-si, Gyeonggi-do 16677 (KR)
(74) Representative: Appleyard Lees IP LLP
(86) International application number: PCT/KR2024/010335
(87) International publication number: WO 2025/018804

(57) **Abstract**

According to an embodiment, an electronic device may include a flexible display, a bracket, and a damping member. The flexible display may include a first display area having a first thickness and a second display area having a second thickness which is thinner than the first thickness. The bracket may support the flexible display. At least a part of the bracket may be disposed between the flexible display and a battery. The bracket may include a first support area facing the second display area and having a third thickness. The damping member may be attached to the first support area and the flexible display. The bracket may include a second support area facing the second display area, extended from the first support area and having a fourth thickness which is thinner than the third thickness. The first damping member may be disposed between the second display area and the second support area. Various other embodiments are possible.

## Description

### [Technical Field]

The disclosure relates to an electronic device including a flexible display and a structure thereof.

### [Background Art]

An electronic device may include a flexible display. The flexible display may include a structure in which an area where a screen is displayed is flexibly deformed. The flexible display may be deformed not only into a flat panel shape but also into other shapes. For example, an electronic device including a flexible display may be implemented by a foldable type such that it is folded or unfolded with reference to at least one folding axis.

The above-described information is provided as a related-art technology for the purpose of easy understanding of the disclosure. Any assertion or decision is not presented as to what content of the above-described contents to apply as prior art in relation to the disclosure.

### [Disclosure of Invention]

### [Solution to Problem]

According to an embodiment, an electronic device may include a flexible display, a bracket, and a damping member. The flexible display may include a first display area having a first thickness and a second display area having a second thickness which is thinner than the first thickness. The bracket may support the flexible display. The bracket may include a first support area facing the second display area and having a third thickness. The bracket may include a second support area extended from the first support area and having a fourth thickness which is thinner than the third thickness. The damping member may be disposed between the second display area and the second support area.

### [Brief Description of Drawings]

FIG. 1 is a block diagram of an electronic device in a network environment according to various embodiments;
FIG. 2 is a view illustrating an example of an exterior of the electronic device in a flat state according to an embodiment;
FIG. 3 is a view illustrating an example of an exterior of the electronic device in a folded state according to an embodiment;
FIG. 4 is an exploded perspective view of an example of an electronic device according to an embodiment;
FIG. 5 is a view illustrating a cross section of a flexible display included in the electronic device according to an embodiment;
FIG. 6 is a view conceptually illustrating a structure in a second housing of the electronic device according to an embodiment;
FIG. 7 is a top view illustrating arrangements of inner components of the electronic device according to an embodiment;
FIG. 8 is a cross-sectional view illustrating an example of arrangements of a bracket and a damping member which are included in the electronic device according to an embodiment;
FIG. 9 is a view conceptually illustrating examples of a layered structure of the damping member according to an embodiment;
FIG. 10 is a view illustrating an example of a damping member including a plurality of through holes according to an embodiment;
FIG. 11 is a view conceptually illustrating a structure of the through hole of the damping member according to an embodiment;
FIG. 12 is a view illustrating an example of a layered structure of a damping member according to an embodiment;
FIG. 13 is a view illustrating an example of a layered structure of a damping member that is applied when an opening is formed in a bracket according to an embodiment;
FIG. 14 is a view illustrating a cross-section of an electronic device which further includes an auxiliary adhesive member according to an embodiment;
FIG. 15 is a view illustrating an area in which the auxiliary adhesive member is disposed in the electronic device according to an embodiment;
FIG. 16 is a cross-sectional view illustrating a structure in a first housing according to an embodiment; and
FIG. 17 is a view illustrating a layered structure of a flexible display according to an embodiment.

### [Mode for Carrying out the Invention]

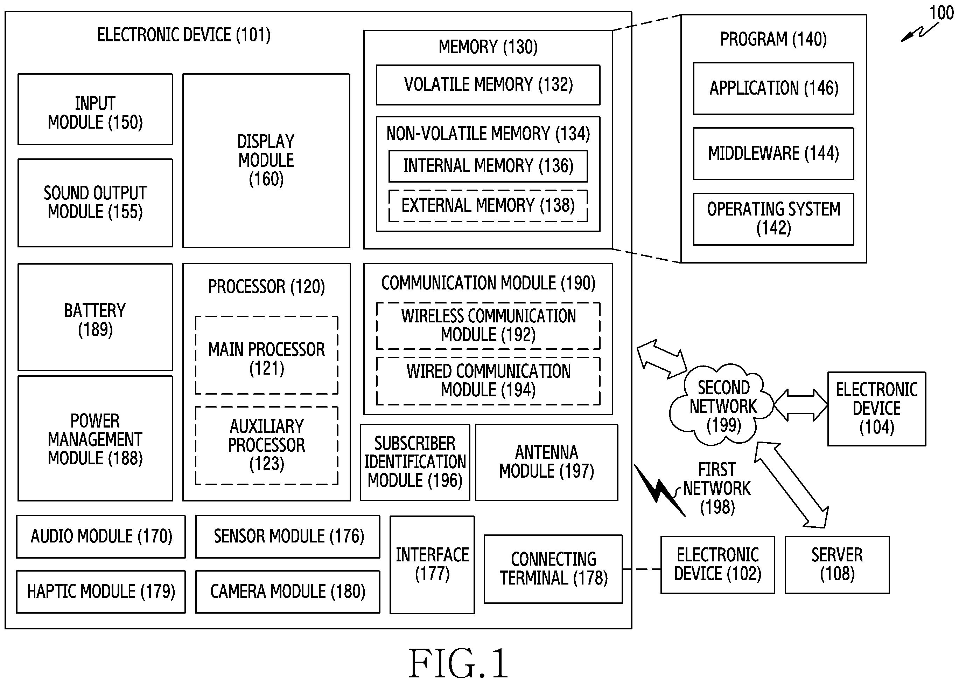

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

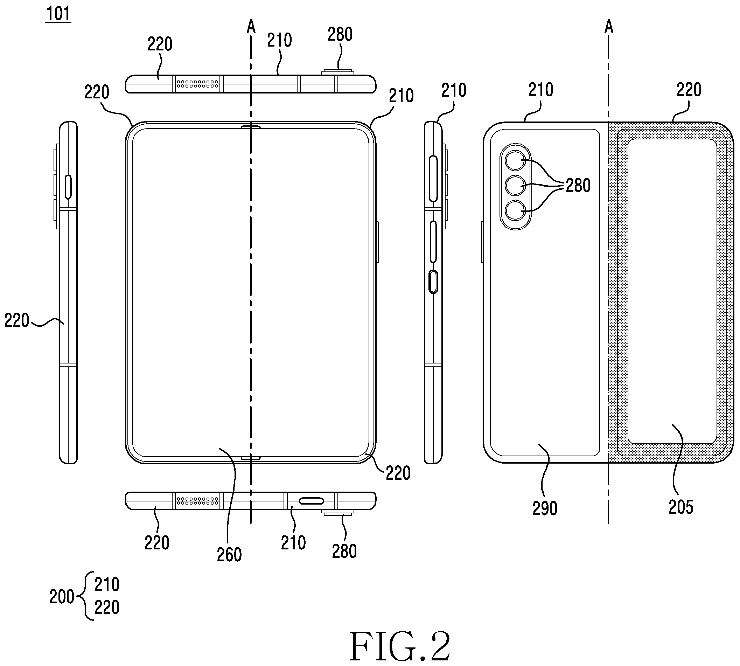

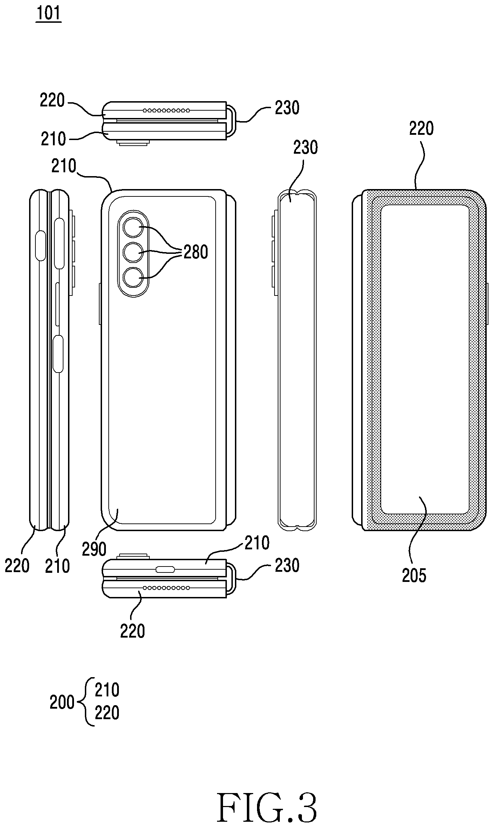

FIG. 2 is a view illustrating an example of an exterior of an electronic device 101 in a flat state according to an embodiment. FIG. 3 is a view illustrating an example of the exterior of the electronic device 101 in a folded state according to an embodiment.

Referring to FIGS. 2 and 3, in an embodiment, the electronic device 101 may include a foldable housing 200, a folding part 230 (for example, a hinge and a hinge cover) disposed in a foldable portion of the foldable housing 200, and a flexible display 260 disposed in a space formed by the foldable housing 200. In the disclosure, a surface on which the flexible display 260 is disposed may be referred to as a front surface of the electronic device 101. In addition, in the disclosure, the opposite surface of the front surface may be referred to as a rear surface. In addition, in the disclosure, a surface surrounding a space between the front surface and the rear surface may be referred to as a side surface of the electronic device 101.

In an embodiment, the foldable housing 200 may include a first housing structure 210 and a second housing structure 220. The first housing structure 210 may be referred to as a first housing. The second housing structure 220 may be referred to as a second housing. The first housing structure 210 may include a back cover 290. The foldable housing 200 of the electronic device 101 is not limited to the shape and coupling illustrated in FIGS. 2 and 3, and may be implemented by a combination and/or coupling of other shapes or components. For example, in an embodiment, the first housing structure 210 and the back cover 290 may be integrally formed with each other.

In an embodiment, the first housing structure 210 and the second housing structure 220 may be disposed on both sides with reference to a folding axis A, and may have side surfaces substantially symmetrical with respect to the folding axis A. As will be described below, a state of the electronic device 101 may be referred to as a flat/open state, a folded state, or an intermediate state according to an angle or a distance formed by the first housing structure 210 and the second housing structure 220. In an embodiment, the first housing structure 210 and the second housing structure 220 may have a substantially symmetrical shape, but may have different shapes in part. Referring to FIG. 2, the first housing structure 210 may include the back cover 290 in which at least one camera 280 is disposed. The second housing structure 220 may include a structure that has a display 205 disposed on a rear surface thereof.

In an embodiment, the first housing structure 210 and the second housing structure 220 may form a shape together to accommodate the flexible display 260. The back cover 290 may be disposed on one side of the folding axis A on the rear surface of the electronic device 101. A periphery of the back cover 290 may be enclosed by the housing structure 210.

In an embodiment, the first housing structure 210 and the second housing structure 220 may form a space to have various components (for example, a printed circuit board, a battery) of the electronic device 101 disposed therein. In an embodiment, one or more components or a sensor may be disposed on the rear surface of the electronic device 101 or may be visually exposed. For example, lenses of at least one camera 280 may be visually exposed through the back cover 290.

Referring to FIG. 3, in an embodiment, the folding part 230 may be disposed between the first housing structure 210 and the second housing structure 220, and may be configured to have an inner component (for example, a hinge structure). In an embodiment, the folding part 230 may have at least a part hidden by the first housing structure 210 and the second housing structure 220, or exposed to the outside, according to a state (a flat state, a folded state, or an intermediate state) of the electronic device 101.

For example, when the electronic device 101 is in a flat state as shown in FIG. 2, the folding part 230 may be hidden by the first housing structure 210 and the second housing structure 220 and may not be exposed. For example, when the electronic device 101 is in a folded state (for example, a fully folded state) as shown in FIG. 3, the folding part 230 may have at least a part exposed to the outside between the first housing structure 210 and the second housing structure 220. For example, in an intermediate state in which the first housing structure 210 and the second housing structure 220 are folded with a certain angle, the folding part 230 may have at least a part exposed to the outside between the first housing structure 210 and the second housing structure 220. For example, the exposed area of the folding part 230 may be smaller than that in the fully folded state. In an embodiment, the exposed area of the folding part 230 may include a curved surface.

In an embodiment, the flexible display 260 may be disposed on a space formed by the foldable housing 200. For example, at least part of the flexible display 260 may be disposed along one surface defined along the first housing structure 210 and one surface defined along the second housing structure 220. The rear surface of the electronic device 101 may include the back cover 290 and the display 205.

In an embodiment, the flexible display 260 may include a display that has at least some areas deformable to a flat surface or a curved surface. The flexible display 260 may be divided into a plurality of areas according to a structure function.

In an embodiment, when the electronic device 101 is in a flat state (for example, FIG. 2), a first surface on the first housing structure 210 on which the flexible display 260 is disposed, and a second surface on the second housing structure 220 on which the flexible display 260 is disposed may form an angle of about 180°. An area of the flexible display 260 corresponding to the first housing structure 210, and an area corresponding to the second housing structure 220 may face substantially in the same direction. In the flat state of the electronic device 101, a facing direction of a surface on which the flexible display 260 is disposed may be referred to as a front-facing direction.

In an embodiment, when the electronic device 101 is in a folded state (for example, FIG. 3), the first housing structure 210 and the second housing structure 220 may be disposed to face each other. The first surface of the flexible display 260 disposed on the first housing structure 210, and the second surface disposed on the second housing structure 220 may form a small angle (for example, between 0° and 10°) with each other. The first surface and the second surface may face each other. Some areas of the flexible display 260 disposed between the first surface and the second surface may be deformed to have a shape having a predetermined curvature.

In an embodiment, when the electronic device 101 is in an intermediate state, the first housing structure 210 and the second housing structure 220 may be disposed with a certain angle. The first surface of the flexible display 260 disposed on the first housing structure 210, and the second surface disposed on the second housing structure 220 may form an angle that is larger than an angle formed in a folded state and is smaller than an angle in a flat state. Some areas of the flexible display 260 disposed between the first surface and the second surface may be deformed to have a shape having a predetermined curvature. The curvature of some areas of the flexible display 260 in the intermediate state may be smaller than that in a folded state.

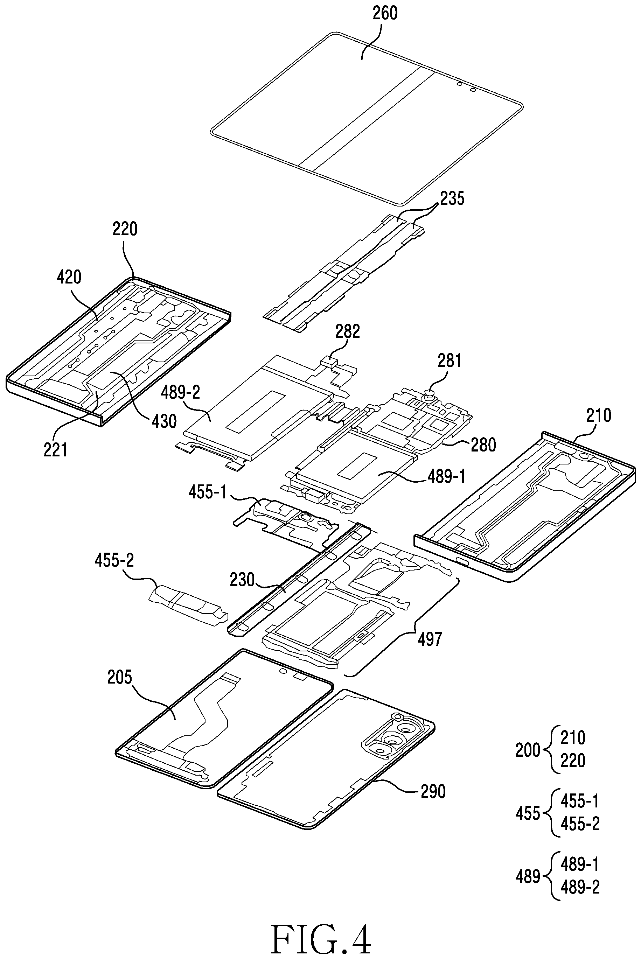

FIG. 4 is an exploded perspective view of an example of an electronic device 101 according to an embodiment.

In an embodiment, the electronic device 101 may include a flexible display 260, a first housing 210, a second housing 220, a battery 489, a folding part 230, at least one plate 235, a front-facing camera 281, a rear-facing camera 280, a speaker module 455, an antenna module 497, a display 205, and a back cover 290.

In an embodiment, the at least one plate 235 may be disposed in a position corresponding to an area in which the flexible display 260 flexes as the first housing 210 and the second housing 220 are folded. The at least one plate 235 may be moved in the electronic device 101 as an angle between the first housing 210 and the second housing 220 is changed. The at least one plate 235 may be disposed to support the flexible display 260 in a state of the electronic device 101 (for example, a flat state). At least a part of the flexible display 260 may be fixed to the first housing 210, and at least a part of the other portion may be fixed to the second housing 220.

In an embodiment, the first housing 210 may include a bracket (or a frame) to have components of the electronic device 101 disposed therein. The bracket disposed on the first housing 210 may be integrally formed with the first housing 210, or may be fixed in the first housing 210 as a separate component. Referring to FIG. 4, at least one camera 280, the front-facing camera 281, the battery 489-1, and the antenna module 497 which are exposed to the rear surface of the electronic device 101 may be disposed based on the bracket of the first housing 210. The at least one camera 280 may be optically exposed through the back cover 290 at least in part. The front-facing camera 281 may be disposed to receive light through an area (for example, a hole area or a notch) formed in the flexible display 260 to be transparent. Alternatively, the front-facing camera 281 may include a under display camera (UDC) which receives light through the flexible display 260 without a separate transparent area in the flexible display 260. The battery 489-1 may store power and may supply stored power to at least one component included in the electronic device 101. The antenna module 497 may include at least one of at least one antenna or at least one radio frequency integrated circuit (RFIC) to perform communication. For example, the antenna module 497 may include at least one of a main antenna, a sub antenna, an antenna for performing ultra wide-band (UWB) communication, or an antenna for performing near field communication (NFC). Referring to FIG. 4, the at least one camera 280, the front-facing camera 281, the battery 489-1, and the antenna module 497 may be disposed in a space that is at least partially surrounded by the first housing 210, the flexible display 260, and the back cover 290.

In an embodiment, the second housing 220 may include a bracket (or a frame) 221 to have components of the electronic device 101 disposed thereon. The bracket disposed in the second housing 220 may be integrally formed with the second housing 220, or may be fixed to the second housing 220 as a separate component. Referring to FIG. 4, the rear-facing camera 282, the battery 489-2, the speaker module 455, an adhesive member 420, and a first damping member 430 may be disposed based on the bracket 221 of the second housing 220. The rear-facing camera 282 may be disposed to receive light through an area (for example, a hole area or a notch area) formed on the display 205 to be transparent. The rear-facing camera 282 may include a UDC to receive light through the display 205. The battery 489-2 may store power and may supply stored power to at least one component of the electronic device 101. The speaker module 455 may include at least one speaker to output a sound. For example, the speaker module 455 may include an upper speaker 455-1 to output a sound through an upper end (for example, an area of the second housing 220 adjacent to the rear-facing camera 282) of the electronic device 101. The speaker module 455 may include a lower speaker 455-2 to output a sound through a lower end (the opposite side of the upper end) of the electronic device 101. The adhesive member 420 may be attached to the flexible display 260 and the bracket 221 to form a waterproof area which is a space into which a liquid does not flow from the outside between the flexible display 260 and the bracket 221. The adhesive member 420 may include, for example, a waterproof tape. The first damping member 430 may include a material that buffers an impact generated by a collision of the flexible display 260 with the bracket 221 of a stiff material. For example, the first damping member 430 may include at least one of a porous foam or elastomer. Referring to FIG. 4, the rear-facing camera 282, the battery 489-2, the speaker module 455, the adhesive member 420, and the first damping member 430 may be disposed in a space that is at least partially surrounded by the second housing 220, the display 205, and the flexible display 260.

In an embodiment, the folding part 230 may include a hinge structure which rotatably connects the first housing 210 and the second housing 220, a hinge cover disposed to prevent the hinge structure from being exposed to the outside, and at least one plate 235 connected with the hinge structure.

The components illustrated in FIG. 4 and arrangements of the components are just for explanation of an embodiment, and some components may be changed or their positions may be changed. For example, although it is illustrated in FIG. 4 that the front-facing camera 281 is disposed in the first housing 210 and the rear-facing camera 282 is disposed in the second housing 220, the front-facing camera 281 may be disposed in the second housing 220 and the rear-facing camera 282 may be disposed in the first housing 210.

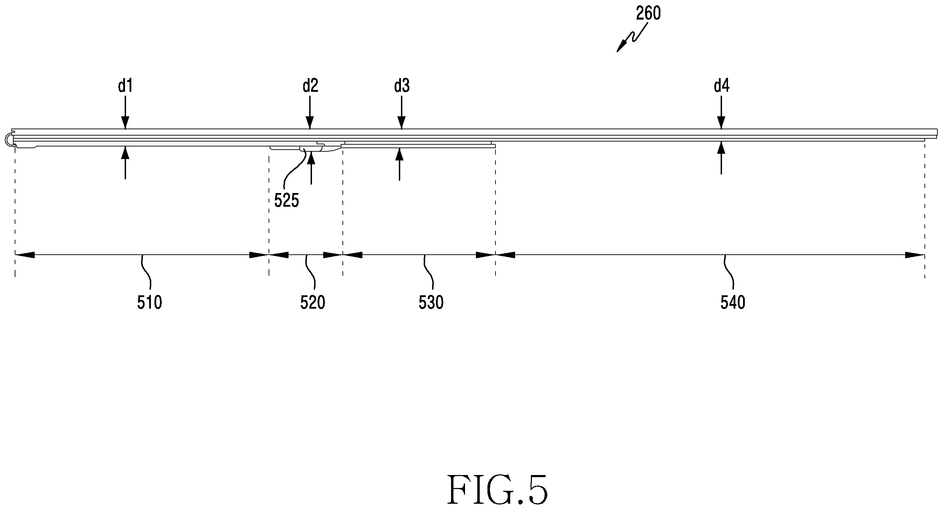

FIG. 5 is a view illustrating a cross-section of the flexible display 260 included in the electronic device 101.

According to an embodiment, the flexible display 260 may include a first display area 520 having a thickness of at least a first thickness d2, and a second display area 540 having a second thickness d4 which is thinner than the first thickness d2. For example, the first display area 520 may include an area where a display driver IC (DDI) 525 is disposed. The display driver IC 525 may be connected to one end of a third display area 510 (chip on plastic (COP) area) of the flexible display 260. For example, the third display area 510 may include an area in which a circuit is disposed on the flexible display 260. The flexible display 260 may further include a fourth display area (micro flexible printed circuit board (MFPCF) area) 530 extended from the first display area 520. At least one flexible printed circuit board may be disposed in the fourth display area 530. However, FIG. 5 is just provided to explain an example of the flexible display 260 having different thicknesses, and a detailed configuration of the flexible display 260 may be changed within the scope of an embodiment.

Since a component needed to perform a display operation (for example, the display driver IC 525) should be mounted in the flexile display 260 according to an embodiment, the thickness may not be uniform. The second display area 540 in which a component is not mounted may have a thickness d4 which is thinner than thicknesses d1, d2, d3 of the other areas. The thicknesses d1, d2, d3, d4 of the display areas may be, for example, 300 *µ*m to 2000 *µ*m inclusive. For example, the first thickness d2 of the first display area 520 among the thicknesses d1, d2, d3, d4 may be thickest, and the second thickness d4 of the second display area 540 may be thinnest. The thickness d1 of the third display area 510 may be similar to the thickness d3 of the fourth display area 530.

The flexible display 260 according to an embodiment may have at least a part seated in the bracket 221 of the electronic device 101. Since the thickness of the flexible display 260 is not uniform, a step corresponding to the thickness of the flexible display 260 may be formed on one surface of the bracket 221 in which the flexible display 260 is seated.

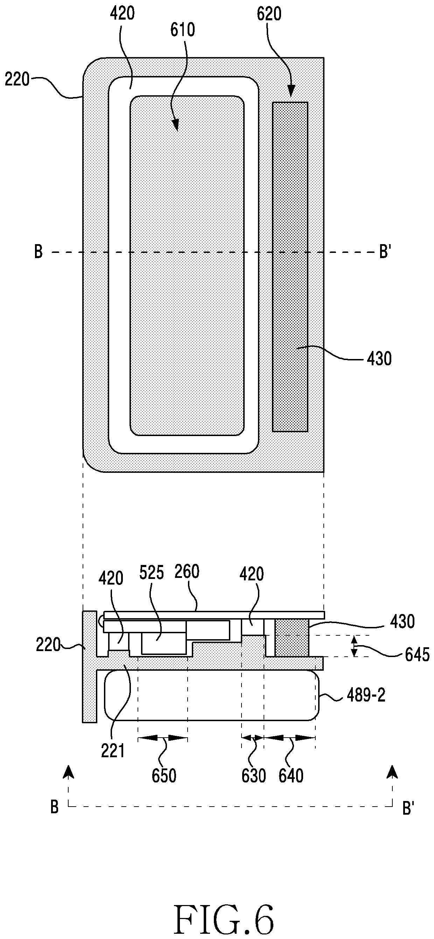

FIG. 6 is a view conceptually illustrating a structure in the second housing 220 of the electronic device 101 according to an embodiment.

According to an embodiment, the electronic device 101 may include a battery 489-2, a flexible display 260, and a bracket 221 which has at least a part disposed between the flexible display 260 and the battery 489-2. The electronic device according to an embodiment may include an adhesive member 420 attached between the flexible display 260 and the bracket 221. The adhesive member 420 may have a first surface attached to the flexible display 260. The adhesive member 420 may have a second surface, the opposite surface of the first surface, attached to the bracket 221. A waterproof area 610 may be formed by the flexible display 260, the bracket 221, and the adhesive member 420 to prevent a liquid from flowing from the outside. An external space of the waterproof area 610 may be referred to as a non-waterproof area 620. The bracket 221 may be disposed across the waterproof area 610 and the non-waterproof area 620. However, the term "non-waterproof" is used to indicate a space compared to the waterproof area 610, and a waterproof function may be implemented for the non-waterproof area 620 by other structure.

According to an embodiment, the bracket 221 may include a first support area 630 to which the adhesive member 420 is attached, and a second support area 640 in which a first damping member 430 is disposed. Since the bracket 221 should have a thickness of at least a minimum thickness in order to maintain stiffness, a third thickness of the first support area 30 for having the adhesive member 420 disposed thereon may be thicker than a fifth thickness d7 of a third support area 650 on which a display driver IC 525 is disposed. When all portions of the bracket 221 disposed in the non-waterproof area 620 are formed to have the third thickness, the weight of the bracket 221 may increase since the bracket 221 is made of a stiff material such as metal. In addition, when the bracket 221 is formed to have the third thickness, a space for increasing a thickness of the first damping member 430 may be reduced. In order to reduce the weight of the bracket 221 and to ensure a space to have the first damping member 430 disposed therein, the second support area 640 may have a fourth thickness which is thinner than the third thickness. A step 645 may be formed between the first support area 630 and the second support area 640. The fourth thickness d6 of the second support area 640 may be equal to or thinner than the fifth thickness d7 of the third support area 650.

In an embodiment, the first damping member 430 may be disposed on the second support area 640. As the fourth thickness d6 of the second support area 640 is thinner than the third thickness d5 of the first support area 630, the thickness of the first damping member 430 may increase by a height corresponding to the step 645. The first damping member 430 may be formed with a material having a light specific weight (weight per unit volume) compared to the bracket 221.

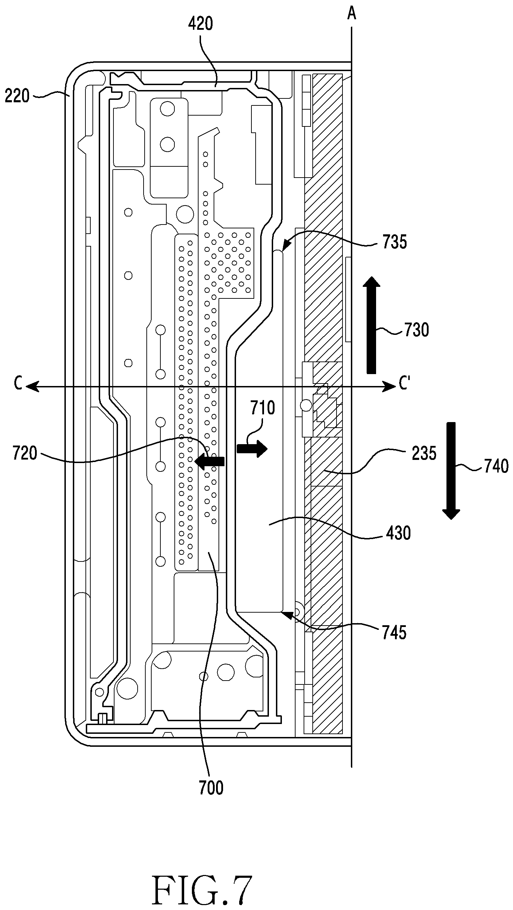

FIG. 7 is a top view showing arrangements of inner components of the electronic device 101 according to an embodiment.

The electronic device 101 according to an embodiment may include an adhesive member 420 disposed in the second housing 220, and a plate 235 disposed on one side along the folding axis. The adhesive member 420 may be disposed in the second housing 220. The adhesive member 420 may be disposed to surround an area where components (for example, the display driver IC 525) that need to be protected from moisture are disposed in order to form the waterproof area 610.

In an embodiment, a first damping member 430 may be disposed between the adhesive member 420 and the plate 235. The first damping member 430 may be disposed in a first direction 710 with reference to the adhesive member 420 to face the folding part 230. The first damping member 430 may be disposed in an area where the plate 235 is not disposed, such that the flexible display 260 may be prevented from being damaged due to a collision with a stiff structure (for example, the bracket 221) in the electronic device 101, caused by an external impact. The first damping member 430 may be spaced apart from the plate 235.

In an embodiment, the first damping member 430 may be disposed to be placed in a longitudinal direction of the first damping member 430, which is substantially parallel to the direction of the folding axis A. The longitudinal direction of the first damping member 430 may refer to a direction of the longest length of the first damping member 430.

In an embodiment, the electronic device 101 may further include a second damping member 700 which is disposed within an area surrounded by the adhesive member 420. The second damping member 700 may be disposed in a second direction 720 which is the opposite direction of the first direction 710 facing the folding part 230 with respect to at least a part of the adhesive member 420. The first damping member 430 may be thicker than the second damping member 700.

In an embodiment, the first damping member 430 may be disposed in an area corresponding to an area where the battery 489-2 is disposed. For example, one end 735 of the first damping member 430 in a third direction 730, and one end 745 in a fourth direction 740 may be disposed at positions corresponding to positions of one end and another end of the battery 489-2.

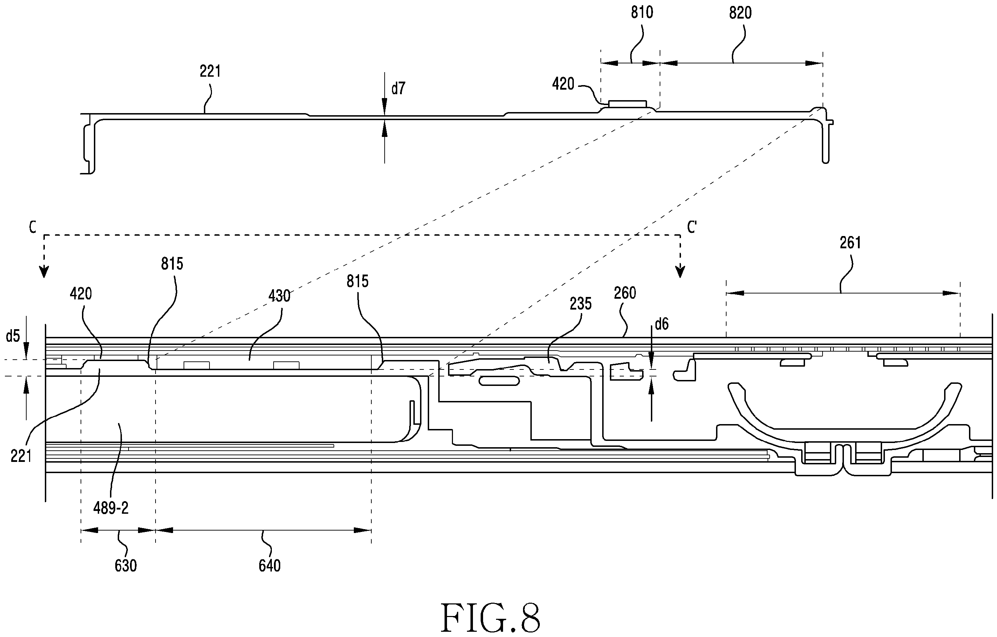

FIG. 8 is a cross-sectional view illustrating an example of arrangements of the bracket 221 and the first damping member 430 included in the electronic device 101 according to an embodiment. FIG. 8 is a view taken on line C-C' of FIG. 7.

In an embodiment, the bracket 221 may include an area 820 that is extended from an area 810 in which the adhesive member 420 is attached. In an embodiment, a slimming process may be performed on the extended area 820, such that the extended area 820 may form a second support area 640 that has a thickness thinner than a thickness d5 of the area 810 in which the adhesive member 420 is attached. For example, the third thickness d5 may be greater than or equal to 0.694 T, and a fourth thickness d6 may be less than or equal to 0.3 T.

In an embodiment, referring to FIG. 8, the second support area 640 may include a recess to accommodate at least a part of the first damping member 430. The first damping member 430 may be mounted in the recess formed on the second support area 640, such that a thickness of the first damping member 430 may be guaranteed. As the thickness of the first damping member 430 increases, it is more advantageous to guarantee a space for damping an external impact.

In an embodiment, the bracket 221 may include a chamfered structure 815 formed at a position where a step is formed between the second support area 640 and the first support area 630. The chamfered structure 815 may include a curved surface or an inclined surface. When a periphery of the second support area 640 is sharpened, the flexible display 260 may collide with a corner, causing a damage. Through the chamfered structure 815 formed on a periphery of the second support area 640, the probability of occurrence of a damage may be reduced even when the flexile display 260 collides. A gap may be formed between the chamfer 815 and the damping member 430 by considering an error occurring in a manufacturing process. For example, the damping member 430 may be disposed to be spaced apart from the chamfer 815 by a distance corresponding to 0.2 T.

In an embodiment, the flexible display 260 may include a lattice area 261 in which a lattice pattern is formed. A layer including the lattice area 261 in the flexible display 260 may be referred to as a lattice layer. The lattice area 261 may be formed in an area that includes at least one folding axis A of the electronic device 101. The adhesive member 420 may be bonded to the lattice layer. The damping member 430 may be disposed to face the lattice layer.

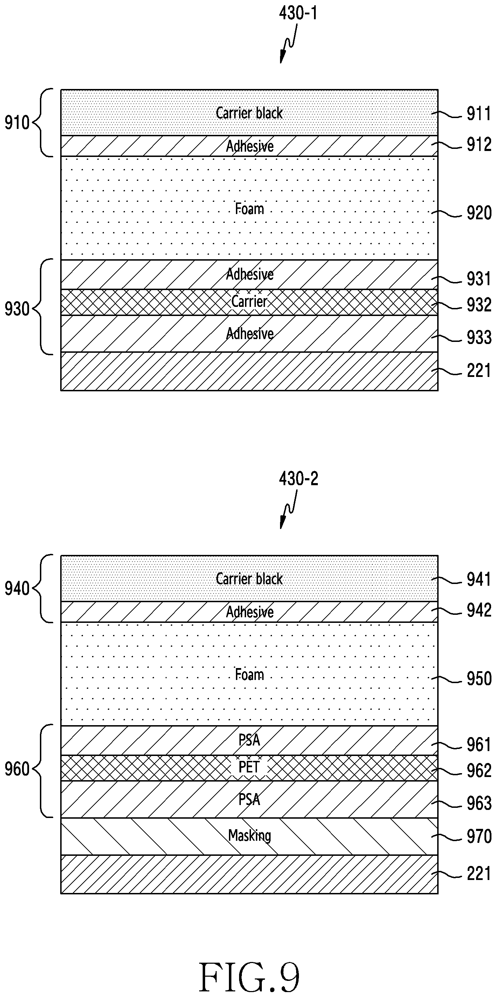

FIG. 9 is a view conceptually illustrating examples of a layered structure of a damping member 430 according to an embodiment.

In an embodiment, a damping member 430-1 may be configured to include a plurality of layers 910, 920, 930. The plurality of layers 910, 920, 930 may include a top layer 910 and a foam layer 920. The top layer 910 may include a cover layer 911 facing the flexible display 260. The foam layer 920 may generate a sound due to stickiness of a surface when the foam layer is separated from the flexible display 260 if the foam layer directly contacts the flexible display 260. In an embodiment, the cover layer 911 may be formed with a material that does not generate a sound when the cover layer is separated from the flexible display 260 even if the cover layer directly contacts the flexible display 260. In an embodiment, the cover layer 911 may be formed with a black material. The cover layer 911 may be attached to the foam layer 920 by a first adhesive layer 912. The foam layer 920 may include a material that is deformable by an external force and damps an impact. For example, the foam layer 920 may include a porous material such as sponge. However, this should not be considered as limiting, and the foam layer 920 may be formed with other materials for damping an impact.

In an embodiment, the foam layer 920 may occupy most of the thickness of the damping member 430-1. For example, the cover layer 911 may be 5-9 *µ*m thick, the first adhesive layer 912 may be 1-5 *µ*m thick, the foam layer 920 may be 100-500 *µ*m thick, a second adhesive layer may be 1-5 *µ*m thick, a transparent layer 932 may be 1-4 *µ*m thick, and a third adhesive layer 933 may be 1-5 *µ*m thick. However, this should not be considered as limiting.

In an embodiment, the foam layer 920 may be attached to the bracket 221 by the bottom layer 930. The bottom layer 930 may include the second adhesive layer 931, the transparent layer 932, and the third adhesive layer 933. The transparent layer 932 may be formed with a transparent material. The transparent layer 932 may be attached to the foam layer 920 by the second adhesive layer 931. The transparent layer 932 may be attached to the bracket 221 by the third adhesive layer 933.

In an embodiment, a damping member 430-2 may include a plurality of layers 940, 950, 960, 970. The plurality of layers 940, 950, 960, 970 may include a top layer 940 and a foam layer 950. The top layer 910 may include a cover layer 941 facing the flexible display 260. The foam layer 950 may generate a sound due to stickiness of a surface when the foam layer is separated from the flexible display 260 if the foam layer directly contacts the flexible display 260. In an embodiment, the cover layer 941 may be formed with a material that does not generate a sound when the cover layer is separated from the flexible display 260 even if the cover layer directly contacts the flexible display 260. In an embodiment, the cover layer 941 may be formed with a black material. The cover layer 941 may be attached to the foam layer 950 by a first adhesive layer 942. The foam layer 950 may include a material that is deformable by an external force and damps an impact. For example, the foam layer 950 may include a porous material such as sponge. However, this should not be considered as limiting, and the foam layer 950 may be formed with other materials for damping an impact.

In an embodiment, the foam layer 950 may occupy most of the thickness of the damping member 430-2. For example, the cover layer 941 may be 5-9 *µ*m thick, the first adhesive layer 942 may be 1-5 *µ*m thick, the foam layer 950 may be 100-500 *µ*m thick, a first pressure sensitive adhesive (PSA) layer 961 may be 10-30 *µ*m thick, a PET layer 962 may be 5-17 *µ*m thick, a second PSA layer 963 may be 10-22 *µ*m thick, and a masking layer 970 may be 5-15 *µ*m thick. However, this should not be considered as limiting.

In an embodiment, the foam layer 950 may be attached to the bracket 221 by a bottom layer 960 and the masking layer 970. The bottom layer 960 may include the first pressure sensitive adhesive (PSA) layer 961, the poly-ethyleneterephthalate (PET) layer 962, and the second PSA layer 963. The bottom layer 960 may be formed with a transparent material. The PET layer 962 may be attached to the foam layer 950 by the fist PSA layer 961. The PET layer 962 may be attached to the masking layer 970 attached to the bracket 221 by the second PSA layer 963. The masking layer 970 may be formed with a colored material (for example, white).

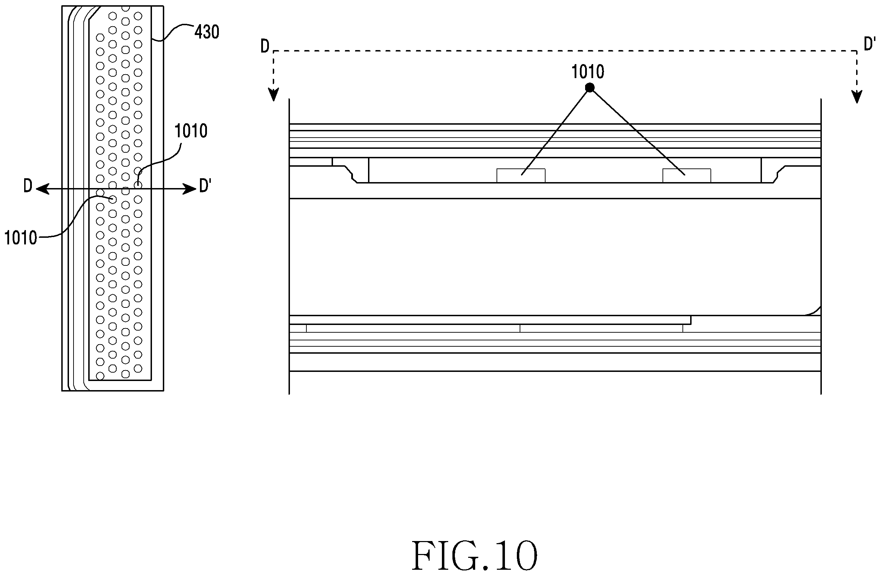

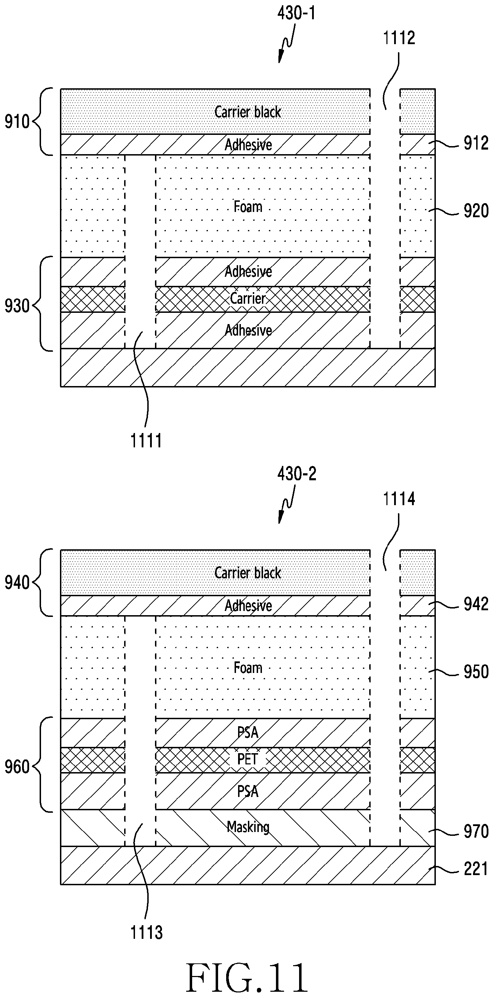

FIG. 10 is a view illustrating an example of a damping member 430 (for example, the damping member 430 of FIG. 4, 6, 7, or 8 or the damping member 430-1, 430-2 of FIG. 9 or 11) including a plurality of through holes 1010 according to an embodiment.

In an embodiment, the damping member 430 may include through holes 1010 penetrating through at least one layer among a plurality of layers of the damping member 430. The plurality of through holes 1010 may be formed in the damping member 430, such that a damping function of the damping member 430 may be maintained and a weight of the damping member 430 may be reduced. The plurality of through holes 1010 may be distributed along at least one layer of the damping member 430, and disposed.

FIG. 11 is a view conceptually illustrating a structure of a through hole of a damping member 430 according to an embodiment.

In an embodiment, a damping member 430-1 may include a through hole 1111 penetrating through at least one of a foam layer 920 or a bottom layer 930. In an embodiment, the damping member 430-1 may include a through hole 1112 penetrating through all of the plurality of layers 910, 920, 930. In the embodiment including the through hole 1112 penetrating through all of the plurality of layers 910, 920, 930, when an adhesive is leaked from a first adhesive layer 912 or the bottom layer 930 along the through hole 1112, the top layer 910 may be adhered to the flexible display 260. The top layer 910 may be configured to cover the through hole 1111 to prevent an adhesive from being moved between the top layer 910 and the flexible display 260.

In an embodiment, a damping member 430-2 may include a through hole 1113 penetrating through at least one of a foam layer 950, a bottom layer 960, or a masking layer 970. In an embodiment, the damping member 430-2 may include a through hole 1114 penetrating through all of the plurality of layers 940, 950, 960 of the damping member 430-2. In the embodiment including the through hole 1114 penetrating through all of the plurality of layers 940, 950, 960, when an adhesive is leaked from a first adhesive layer 942 or the bottom layer 960 along the through hole 1114, the top layer 940 may be adhered to the flexible display 260. The top layer 910 may be configured to cover the through hole 1113 to prevent an adhesive from being moved between the top layer 940 and the flexible display 260.

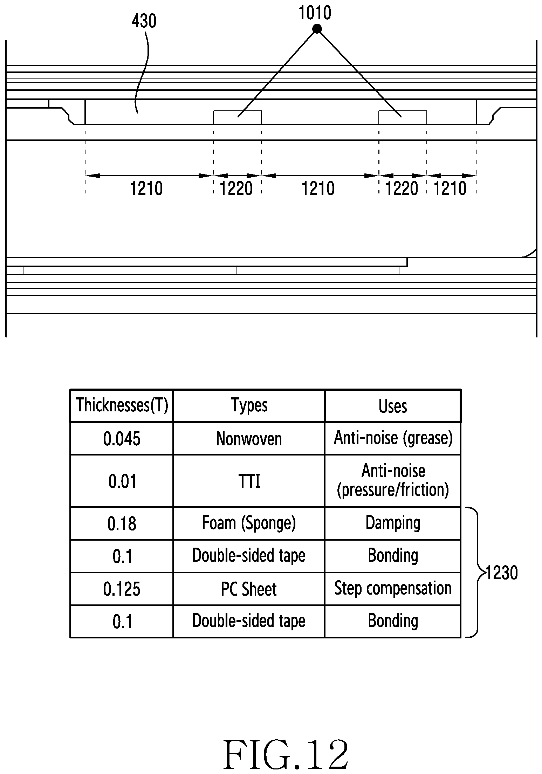

FIG. 12 is a view illustrating an example of a layered structure of a damping member 430 according to an embodiment.

The damping member 430 according to an embodiment may include an area 1210 without a through hole 1010 penetrating through at least some layers, and an area 1220 in which the through hole 1010 is formed. The area without the through hole 1010 may include a nonwoven layer and a TTI layer for preventing a sound generated from a contact surface contacting the flexible display 160, a foam (sponge) layer for performing a damping operation, a PC sheet having a tape attached to both sides thereof in order to attach the foam layer to the bracket 221. In the area in which the through hole 1010 is formed, a foam and bottom layer 1230 including a foam layer and a PC sheet having a tape attached to both sides thereof may be omitted.

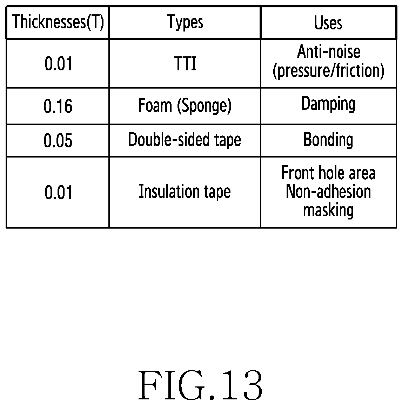

FIG. 13 illustrates an example of a layered structure of a damping member 430 which is applied when an opening is formed in the bracket 221 according to an embodiment.

In an embodiment, when an opening exists in a certain area (for example, the second support area 640) of the bracket 221 facing the damping member 430, if the damping member 430 is attached to the bracket 221 by using an adhesive member, a foreign substance may be attached to the adhesive member exposed through the opening. When an opening is formed in the bracket 221, a masking tape having one surface formed with a non-adhesion material may be disposed on a surface facing the bracket 221.

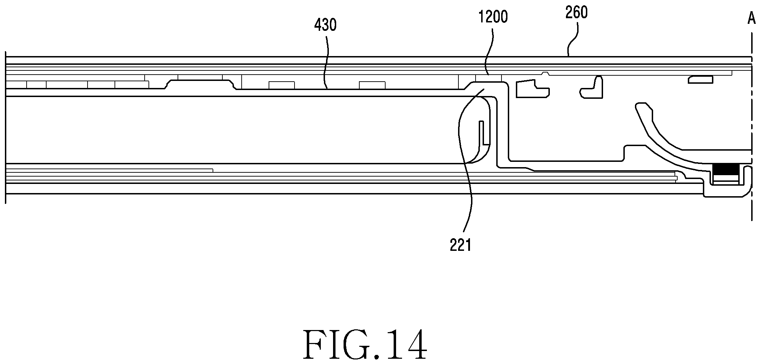

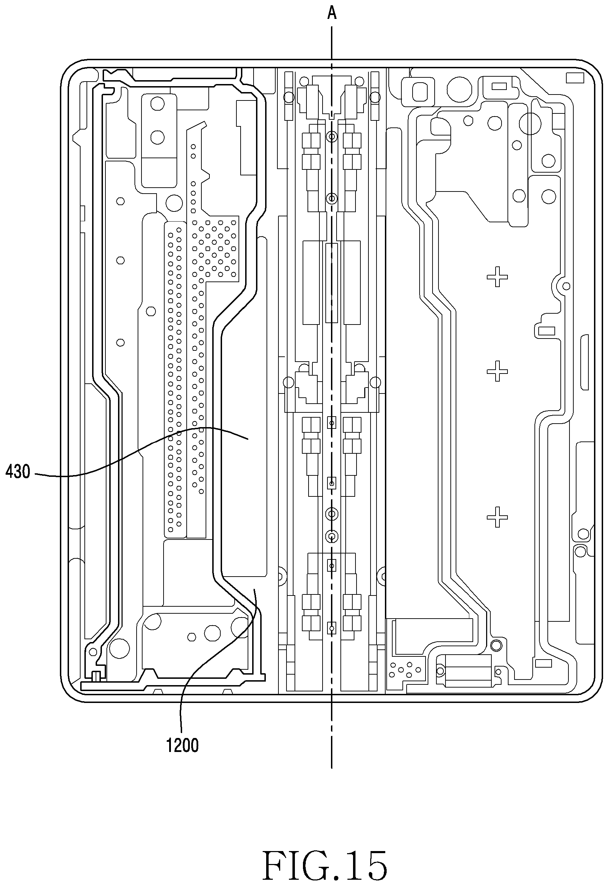

FIG. 14 is a view illustrating a cross section of the electronic device 101 further including an auxiliary adhesive member 1200 according to an embodiment. FIG. 15 is a view illustrating an area in which the auxiliary adhesive member 1200 is disposed in the electronic device 101 according to an embodiment.

In an embodiment, the electronic device 101 may further include the auxiliary adhesive member 1200 which has at least a part disposed between the damping member 430 and the folding axis A. The auxiliary adhesive member 1200 may be attached to the bracket 221 and the flexible display 260. The auxiliary adhesive member 1200 may attach the flexible display 260 to the bracket 221 (or at least one plate 235 of FIG. 4) with respect to an area in which the damping member 430 is not disposed. The auxiliary adhesive member 1200 may include, for example, a double-sided tape or an adhesive coated over an area where the auxiliary adhesive member 1200 is disposed.

In an embodiment, the auxiliary adhesive member 1200 may include a single-sided tape. When the auxiliary adhesive member 1200 includes the single-sided tape, the auxiliary adhesive member 1200 may be attached to the bracket 221 (or at least one plate 235 of FIG. 4), and may perform a role of a damping member to enhance quality of a surface of the flexible display 260 or to improve durability of the flexible display 260.

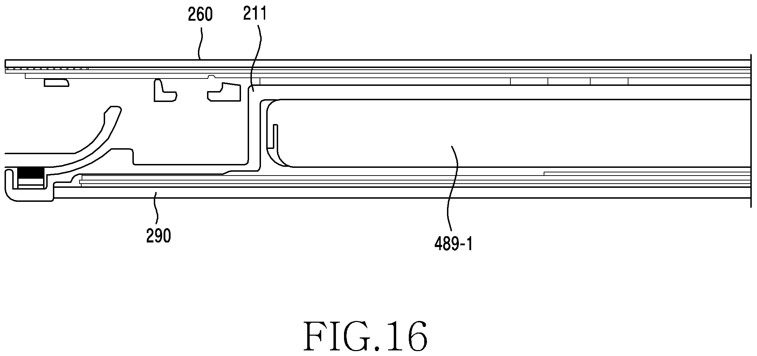

FIG. 16 is a cross-sectional view illustrating a structure in the first housing 210 of the electronic device 101 according to an embodiment.

In an embodiment, a battery 489-1 may be disposed between at least a part of the flexible display 260 disposed in the first housing 210, and the back cover 290. The first housing 210 may include the bracket 211 to support components disposed in the first housing 210. Referring to FIG. 16, the bracket 211 may have at least a part disposed between the battery 489-1 and the flexible display 260.

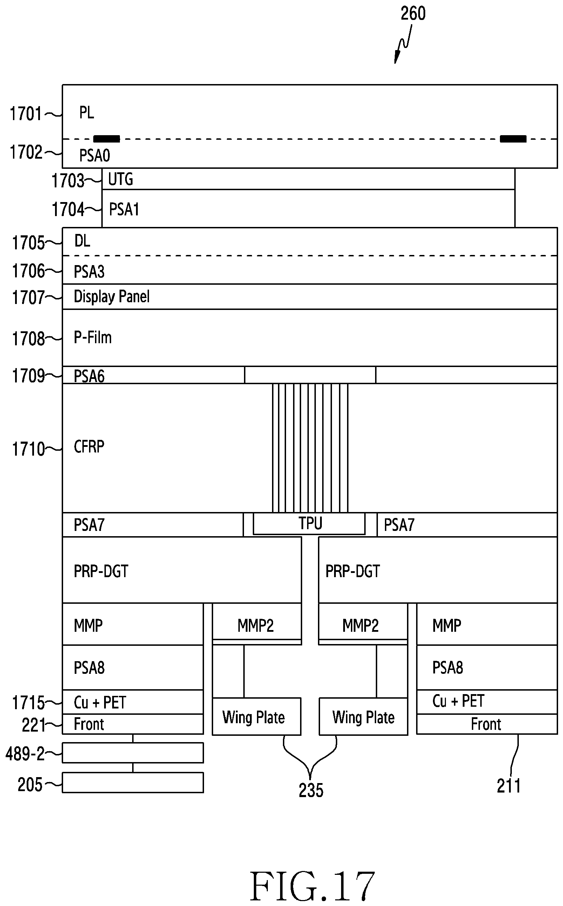

FIG. 17 is a view illustrating a layered structure of the flexible display 260 according to an embodiment.

In an embodiment, the flexible display 260 may be supported by the bracket 211 in the first housing, the bracket 221 in the second housing, and at least one plate 235.

In an embodiment, the flexible display 260 may include a protection layer (PL) 1701, ultra-thin glass (UTG) 1703, a damping layer (DL) 1705, a display panel 1707, a protection film 1708, a carbon fiber reinforced plastics (CFRP) layer 1710, and a copper (Cu) sheet 1715.

The protection layer 1701 may be configured to protect the ultra-thin glass 1703 layer from an external direct impact. The protection layer 1701 may be formed with a transparent polymer material. For example, the protection layer 1701 may include a polyethylene terephthalate (PET) material. The protection layer 1701 may be attached to the ultra-thin glass 1703 layer by an adhesive layer 1702.

The ultra-thin glass 1703 layer may be configured to reinforce stiffness of the flexible display 260. The ultra-thin glass 1703 layer may protect the display panel 1707 of the flexible display 260 from an external impact. The ultra-thin glass 1703 layer may be attached to the damping layer 1705 by an adhesive layer 1704.

The damping layer 1705 may prevent a damage and/or malfunction of the display panel 1707 by absorbing an impact transmitted to the front surface of the display panel 1707. The damping layer 1705 may be formed with a transparent polymer material (for example, a PET material). The damping layer 1705 may be attached to the display panel 1707 by an adhesive layer 1706.

The display panel 1707 may include an organic light emitting diodes (OLED) layer to emit light, a circuit to transmit an electrical signal for controlling the OLED layer, and a sealing layer to protect the circuit. The display panel 1707 may further include a touch panel. The display panel 1707 may be formed with a flexible material that has its shape deformed by an external force.

The protection film 1708 may protect the display panel 1707 from an impact transmitted to the rear surface of the display panel 1707. The protection film 1708 may perform a damping role between the display panel 1707 and the CFRP layer 1710. The protection film 1708 may protect a component (for example, a flexible printed circuit board) of the electronic device 101 from a force applied to the front surface of the flexible display 260. The protection film 1708 may be attached to the CFRP layer 1710 by an adhesive layer 1709.

The CFRP layer 1710 may include an area that has a lattice structure in an area corresponding to a folding part (for example, the folding part 230 of FIG. 3) of the electronic device 101. A folding movement of the electronic device 101 and the flexible display 260 may be implemented by the lattice structure. The CFRP layer 1710 may perform a damping role between the display panel 1707 and a digitizer 1712. The CFRP layer 1710 may include various materials. For example, the CFRP layer 1710 may include plastic, carbon nano particles, and polyurethane.

The copper sheet 1715 may diffuse and discharge heat generated in the flexible display 260. The copper sheet 1715 may prevent a magnetic field generated in the digitizer 1712 from being transmitted to the rear surface of the flexible display 260.

The layered structure of the flexible display 260 illustrated in FIG. 17 is merely an example, and the flexible display 260 may be implemented to have other layered structures.

In an embodiment, at least a part of the flexible display 260 may be disposed on one side of the bracket 221. A battery 489-2 may be disposed on the opposite side of the bracket 221. A cover display 205 may be disposed on an outer surface of the electronic device 101 in a direction in which the battery 489-2 is disposed with respect to the bracket 221.

In an embodiment, the cover display 205 may include a flexible display panel disposed in a fixed shape.

In an embodiment, when the electronic device 101 is viewed from above a surface on which the flexible display 260 is disposed in a flat state, layers of the cover display 205 may be disposed to overlap a first display area (for example, 520 of FIG. 5) and a second display area (for example, 530 of FIG. 5) at least partially. When the electronic device 101 is viewed from above the surface on which the flexible display 260 is disposed in the flat state, the layers of the cover display 205 may be disposed to overlap an adhesive member (for example, 420 of FIG. 6), a first damping member (for example, 430 of FIG. 6), and a display driver IC (for example, 525 of FIG. 5) at least partially.

The disclosure provides an electronic device having a reduced weight of a structure, and a structure thereof.

The disclosure provides an electronic device which may enhance durability of a flexible display included in the electronic device while reducing a weight of a structure, and a structure thereof.

The technical objects to be achieved by the disclosure are not limited to those mentioned above, and other technical objects that are not mentioned above may be clearly understood to those skilled in the art based on the descriptions of the disclosure.

According to an embodiment, an electronic device may include a flexible display 260, a bracket 221, and a damping member 430, 430-1, 430-2. The flexible display 260 may include a first display area 520 having a first thickness d2 and a second display area 540 having a second thickness d4 which is thinner than the first thickness d2. The bracket 221 may support the flexible display 260. At least a part of the bracket 221 may be disposed between the flexible display 260 and the battery 489-2. The bracket 221 may include a first support area 630 facing the second display area 540 and having a third thickness d5. The damping member 430 may be attached to the first support area 630 and the flexible display area 260. The bracket 221 may include a second support area 640 facing the second display area 540, extended from the first support area and having a fourth thickness d6 which is thinner than the third thickness d5. The damping member 430 may be disposed between the second display area 540 and the second support area 540.

In an embodiment, the flexible display 260 may include a display driver integrated circuit disposed in the first display area 520.

In an embodiment, the second support area 640 may include a recess formed therein and accommodating at least a part of the damping member 430.

In an embodiment, the damping member 430 may include a plurality of layers 910, 920, 930, 940, 950, 960. In an embodiment, a plurality of through holes 1010, 1111, 1112, 1113, 1114 may be formed on the damping member 430 through at least a part of the plurality of layers 910, 920, 930, 940, 950, 960 of the damping member.

In an embodiment, the plurality of through holes 1111, 1113 may be formed to penetrate through at least a part 920, 930, 950, 960 of the plurality of layers 910, 920, 930, 940, 950, 960 of the damping member. The plurality of layers may include a top layer 910, 940 facing the flexible display 260 and covering at least a part of the plurality of through holes.

In an embodiment, the damping member 430 may include a plurality of layers 910, 920, 930, 940, 950, 960. The plurality of layers may include a cover layer 911, a foam layer 920, a first adhesive layer 912, and a bottom layer 930. The cover layer 911 may be disposed to face the flexible display 260. The foam layer 920 may include a material which is deformable by external force. The first adhesive layer 912 may bond the cover layer 911 to a first side of the foam layer 920. The bottom layer 930 may include one side bonded to a second side opposite to the first side of the foam layer 920, and another side bonded to the bracket 221.

In an embodiment, the bracket 221 may include a chamfered structure 815 disposed in a position where a step is formed between the first support area 630 and the second support area 640.

In an embodiment, the damping member 430 may include a plurality of layers 910, 920, 930, 940, 950, 960. The plurality of layers may include a cover layer 941, a foam layer 950, an adhesive layer 942, a masking layer 970, a PET layer 962, a first PSA layer 961, and a second PSA layer 963. The cover layer 941 may be disposed to face the flexible display 260. The foam layer 950 may include a material which is deformable by external force. The adhesive layer 942 may bond the cover layer 941 to a first side of foam layer 950. The masking layer 970 may include a masking tape attached to the bracket 221. The PET layer 962 may be disposed between the foam layer 960 and the masking layer 970. The first PSA layer 961 may bond the PET layer 962 to a second side opposite to the first side of the foam layer 950. The second PSA layer 963 may bond the PET layer 962 to the masking layer 970.

In an embodiment, the foam layer 950 may have a thickness of at least 220 *µ*m.

In an embodiment, the electronic device may further include an adhesive member 420 attached to the second display area 540 and the first support area 630.

In an embodiment, the adhesive member 420 may be attached to an area at least partially surrounding the first display area 520.

In an embodiment, the damping member 430 may be disposed in a first direction 710 with respect to at least a portion of the adhesive member 420. The electronic device may include another damping member 700 disposed in a second direction 720 opposite to the first direction 710 with respect to at least the portion of the adhesive member 420.

In an embodiment, the damping member 430 may be formed such that the damping member is thicker than the other damping member 700.

In an embodiment, the adhesive member 420 may include a waterproof tape.

In an embodiment, the electronic device 101 may further include a second damping member 700 disposed in a space which is sealed by the flexible display 260, the adhesive member 520, and the bracket 221. The first damping member 430 may be formed to have a thickness thicker than the second damping member 700.

In an embodiment, the bracket may include a third support area 650 facing the first display area 520 of the flexible display 260 and having a fifth thickness d7. The fifth thickness d7 may be thinner than the third thickness and thicker than the fourth thickness.

In an embodiment, the adhesive member 420 may include a waterproof tape.

In an embodiment, the electronic device 101 may further include a first housing 210, a second housing 220, and a folding part 230 disposed between the first housing and the second housing and including a hinge structure connecting the first housing 210 and the second housing 220 rotatably about at least one folding axis A. The flexible display 260 may be disposed across the first housing 210, the second housing 220 and the folding part 230. The first display area 520 and the bracket 221 may be disposed in the second housing 220. The second support area may be disposed between the first support area and the hinge structure.

In an embodiment, the bracket 221 may include a third support area 650 facing the first display area 520 of the flexible display 260 and having a fifth thickness d5. The fifth thickness may be thinner than the third thickness and thicker than the fourth thickness.

In an embodiment, the flexible display 260 may include a lattice layer including a lattice area and being disposed on a face facing the bracket 221. The lattice area may include a pattern formed in an area including the at least one folding axis A. The adhesive member 420 may be adhered to the lattice layer.

In an embodiment, the electronic device 101 may further include at least one of a sub-display 205 or a back cover 290 disposed opposite to the flexible display 260, and a battery 489 disposed between the bracket and at least one of the sub-display 205 or the back cover 290. An area where the battery 489 is disposed and an area where the damping member 430 is disposed may be at least partially overlapped, in view in a direction perpendicular to a surface of a region disposed on the second housing 220 of the flexible display 260.

In an embodiment, the electronic device 101 may further include at least one plate 235 disposed in a position corresponding to an area in which the flexible display 260 flexes as the first housing 210 and the second housing 220 are folded.

In an embodiment, the damping member 430 may be disposed between the adhesive member 420 and the at least one plate 235.

In an embodiment, the damping member 430 may be disposed between the adhesive member 420 and the folding part 230, and may be disposed along a direction of the folding axis A.

In an embodiment, the damping member 430 may include at least one opening formed to penetrate through at least a part of the damping member.

In an embodiment, the damping member 430 may include a first layer which is formed with a first material, a second layer which includes a second material different from the first material and is adhered to the first layer, and a third layer which includes a third material different from the second material and is adhered to the second layer.

In an embodiment, a thickness of the second layer may be thicker than a thickness of the first layer and may be thicker than a thickness of the third layer.

In an embodiment, the damping member 430 may include at least one hole penetrating through at least one layer of the first layer, the second layer or the third layer.

In an embodiment, the first layer may include an opaque layer and the third layer may include a transparent layer.

In an embodiment, the second layer may include a porous material.

In an embodiment, the electronic device 101 may further include at least one plate 235 connected to the folding part 230 and supporting at least some areas of the flexible display 260 which is deformed as the first housing 210 and the second housing 220 rotate relative to each other.

In an embodiment, the first damping member 430 may be disposed between the adhesive member 420 and the plate 235.

According to an embodiment, an electronic device 101 may include a battery 489-2, a flexible display 260, a bracket 221, a first damping member 430, 430-1, 430-2, and an adhesive member 420. The bracket 221 may have at least a part disposed between the flexible display 260 and the battery 489-2. The first damping member 430, 430-1, 430-2 may be disposed between the bracket 221 and the flexible display 260. The adhesive member 420 may be attached to a first side of the flexible display 260. The bracket 221 may include a first support area 630 attached to a second side opposite to the first side of the adhesive member 420, and a second support area 640 in which the first damping member is disposed. A step may be formed between the first support area 630 and the second support area 640.

In an embodiment, the first damping member 430 may include a plurality of layers 910, 920, 930, 940, 950, 960. The first damping member 430 may include a plurality of through holes 1010, 1111, 1112, 1113, 1114 penetrating through at least a part of the plurality of layers 910, 920, 930, 940, 950, 960 of the damping member.

In an embodiment, the plurality of layers may include a top layer 910, 940 facing the flexible display 260 and covering at least a part of the plurality of through holes.

In an embodiment, the first damping member 430 may include a plurality of layers 910, 920, 930, 940, 950, 960. The plurality of layers may include a cover layer 911, a foam layer 920, a first adhesive layer 912, and a bottom layer 930. The cover layer 911 may be disposed to face the flexible display 260. The foam layer 920 may include a material which is deformable by external force. The first adhesive layer 912 may bond the cover layer 911 to a first side of the foam layer 920. The bottom layer 930 may include one side bonded to a second side opposite to the first side of the foam layer 920, and another side bonded to the bracket 221.

In an embodiment, the first damping member 430 may include a plurality of layers 910, 920, 930, 940, 950, 960. The plurality of layers may include a cover layer 941, a foam layer 950, an adhesive layer 942, a masking layer 970, a PET layer 962, a first PSA layer 961, and a second PSA layer 963. The cover layer 941 may be disposed to face the flexible display 260. The foam layer 950 may include a material which is deformable by external force. The adhesive layer 942 may bond the cover layer 941 to a first side of foam layer 950. The masking layer 970 may be attached to the bracket 221. The PET layer 962 may be disposed between the foam layer 960 and the masking layer 970. The first PSA layer 961 may bond the PET layer 962 to a second side opposite to the first side of the foam layer 950. The second PSA layer 963 may bond the PET layer 962 to the masking layer 970.

According to various embodiments, there are provided an electronic device which has a reduced weight and a structure thereof.

According to various embodiments, there are provided an electronic device which may enhance durability of a flexible display included in the electronic device, and a structure thereof.

The effects achieved by the disclosure are not limited to those mentioned above, and other effects that are not mentioned above may be clearly understood to those skilled in the art based on the description provided below.

Methods based on the claims or the embodiments disclosed in the disclosure may be implemented in hardware, software, or a combination of both.

When implemented in software, a computer readable storage medium for storing one or more programs (software modules) may be provided. The one or more programs stored in the computer readable storage medium are configured for execution performed by one or more processors in an electronic device. The one or more programs include instructions for allowing the electronic device to execute the methods based on the claims or the embodiments disclosed in the disclosure.

The program (the software module or software) may be stored in a random access memory, a non-volatile memory including a flash memory, a read only memory (ROM), an electrically erasable programmable read only memory (EEPROM), a magnetic disc storage device, a compact disc-ROM (CD-ROM), digital versatile discs (DVDs) or other forms of optical storage devices, and a magnetic cassette. Alternatively, the program may be stored in a memory configured in combination of all or some of these storage media. In addition, the configured memory may be plural in number.

Further, the program may be stored in an attachable storage device capable of accessing the electronic device through a communication network such as the Internet, an Intranet, a local area network (LAN), a wide LAN (WLAN), or a storage area network (SAN) or a communication network configured by combining the networks. The storage device may access via an external port to a device which performs the embodiments of the disclosure. In addition, an additional storage device on a communication network may access to a device which performs the embodiments of the disclosure.

In the above-described specific embodiments of the disclosure, elements included in the disclosure are expressed in singular or plural forms according to specific embodiments. However, singular or plural forms are appropriately selected according to presented situations for convenience of explanation, and the disclosure is not limited to a single element or plural elements. An element which is expressed in a plural form may be configured in a singular form or an element which is expressed in a singular form may be configured in plural number.

In the disclosure, such phrase as "including at least one of a, b, or c" may refer to "including only a", "including only b", "including only c", or "including a combination of two or more elements (including a and b, including band c, including a and c, or including all of a, b, c)".

While specific embodiments have been described in the detailed descriptions of the disclosure, it will be understood by those skilled in the art that various changes in form and details may be made therein without departing from the spirit and scope of the disclosure. Therefore, the scope of the disclosure is defined not by explained embodiments but by the appended claims and equivalents to the claims.

## Claims

1. An electronic device comprising:
a flexible display comprising a first display area having a first thickness and a second display area having a second thickness which is thinner than the first thickness;
a bracket supporting the flexible display, the bracket comprising: a first support area facing the second display area and having a third thickness, and a second support area facing the second display area, extended from the first support area and having a fourth thickness which is thinner than the third thickness; and
a damping member disposed between the second display area and the second support area.

2. The electronic device of claim 1, wherein the flexible display comprises a display driver integrated circuit disposed in the first display area.

3. The electronic device of one of claim 1 or 2, wherein the second support area includes a recess formed therein and accommodating at least a part of the damping member.

4. The electronic device of any preceding claim, wherein the damping member comprises a plurality of layers, and
wherein the damping member comprises a plurality of through holes formed through at least a part of the plurality of layers of the damping member.

5. The electronic device of claim 4, wherein the plurality of through holes are formed to penetrate through at least a part of the plurality of layers of the damping member, and
wherein the plurality of layers comprise a top layer facing the flexible display and covering at least a part of the plurality of through holes.

6. The electronic device of any preceding claim, wherein the damping member comprises a plurality of layers,
wherein the plurality of layers comprise:
a cover layer facing the flexible display;
a foam layer being deformable by external force;
a first adhesive layer bonding the cover layer to a first side of the foam layer; and
a bottom layer comprising one side bonded to a second side opposite to the first side of the foam layer, and another side bonded to the bracket.

7. The electronic device of any of preceding claims, wherein the bracket comprises a chamfered structure disposed in a position where a step is formed between the first support area and the second support area.

8. The electronic device of any preceding claim, wherein the damping member comprises a plurality of layers, and
wherein the plurality of layers comprise:
a cover layer facing the flexible display;
a foam layer deformable by external force;
an adhesive layer bonding the cover layer to a first side of foam layer;
a masking layer attached to the bracket;
a polyethylene terephthalate (PET) layer disposed between the foam layer and the masking layer;
a first pressure sensitive adhesive (PSA) layer bonding the PET layer to a second side opposite to the first side of the foam layer; and
a second PSA layer bonding the PET layer to the masking layer.

9. The electronic device of any preceding claim, further comprising an adhesive member attached to the second display area and the first support area.

10. The electronic device of claim 9, wherein the damping member is disposed in a first direction with respect to at least a portion of the adhesive member, and
wherein the electronic device further comprises another damping member disposed in a second direction opposite to the first direction with respect to at least the portion of the adhesive member.

11. The electronic device of claim 10, wherein the damping member is formed such that the damping member is thicker than the other damping member.

12. The electronic device of any of preceding claim, wherein the adhesive member comprises a waterproof tape.

13. The electronic device of any of preceding claim, further comprising:
a first housing;
a second housing; and
a folding part disposed between the first housing and the second housing and comprising a hinge structure connecting the first housing and the second housing rotatably about at least one folding axis,
wherein the flexible display is disposed across the first housing, the second housing and the folding part,
wherein the first display area and the bracket are disposed in the second housing, and
wherein the second support area is disposed between the first support area and the hinge structure.

14. The electronic device of any of preceding claim, wherein the bracket comprises a third support area facing the first display area of the flexible display and having a fifth thickness, and
wherein the fifth thickness is thinner than the third thickness and thicker than the fourth thickness.

15. The electronic device of claim 13, wherein the flexible display comprises a lattice layer including a lattice area and being disposed on a face facing the bracket,
wherein the lattice area comprises a pattern formed in an area including the at least one folding axis, and
wherein the adhesive member is adhered to the lattice layer.
